**Europäisches Patentamt**

**European Patent Office**

**Office européen des brevets**

(19)

(11) Numéro de publication: **0 090 715**
**B1**

(12)
# FASCICULE DE BREVET EUROPEEN

(45) Date de publication du fascicule du brevet:
**18.12.85**

(51) Int. Cl.⁴: **H 01 R 23/68,** H 05 K 7/20

(21) Numéro de dépôt: **83400572.0**

(22) Date de dépôt: **18.03.83**

(54) **Connecteur de carte imprimée et système de connexion électrique et/ou thermique utilisant un tel connecteur.**

(30) Priorité: **26.03.82 FR 8205250**

(43) Date de publication de la demande:
**05.10.83 Bulletin 83/40**

(45) Mention de la délivrance du brevet:
**18.12.85 Bulletin 85/51**

(84) Etats contractants désignés:
**DE GB IT NL**

(56) Documents cités:
**DE - A - 1 440 198**
**FR - A - 2 185 914**
**US - A - 3 793 609**

(73) Titulaire: **SOCAPEX, 10 bis, quai Léon Blum,**
**F-92153 Suresnes (FR)**

(72) Inventeur: **Bricaud, Hervé, THOMSON-CSF SCPI 173, bld**
**Haussmann, F-75379 Paris Cedex 08 (FR)**
Inventeur: **Casses, Claude, THOMSON-CSF**
**SCPI 173, bld Haussmann, F-75379 Paris Cedex 08 (FR)**

(74) Mandataire: **Ruellan-Lemonnier, Brigitte et al,**
**THOMSON-CSF SCPI 173, boulevard Haussmann,**
**F-75379 Paris Cedex 08 (FR)**

## Description

La présente invention concerne un connecteur de carte imprimée portant des composants électriques à relier à un circuit électrique et/ou une source froide.

Les problèmes de dissipation thermique se posent notamment dans les appareils ou équipements comportant un grand nombre de cartes munies de composants électroniques sous un faible volume. Parmi ces composants, certains d'entre eux dissipent une quantité de chaleur importante qu'il convient d'évacuer dans les meilleures conditions possibles afin de maintenir lesdits composants dans des conditions de fonctionnement acceptables.

Les cartes de circuits imprimés utilisées dans ces équipements électriques sont généralement munies d'un drain thermique ou radiateur en contact thermique direct avec lesdits circuits afin de véhiculer les calories dissipées par ceux-ci vers l'extérieur de l'appareil.

Le brevet français N° 2471059 et le brevet européen EP-A N° 54092 décrivent un connecteur dans lequel le verrouillage de la carte dans le connecteur est réalisé par l'action d'une came sur des contacts plats.

On a toutefois constaté que se pose le problème de verrouillage en fin de rotation de la came du système d'interconnexion: il faut en effet garantir un serrage correct de la carte pour éviter tout risque de desserrage notamment lorsque l'équipement est soumis à des vibrations ou à des chocs. Un tel desserrage engendrerait en effet un mauvais contact entre la carte et le connecteur. En particulier, si la carte est revêtue d'un drain thermique qui assure l'évacuation des calories dissipées par les composants vers le connecteur lui-même relié à une source froide, le desserrage du connecteur engendre une élévation de température des composants supportés par la carte. Suivant l'élévation de température atteinte, on constate soit l'abaissement de la durée de vie des composants (celle-ci peut être divisée par 2 pour une élévation de température de 10°C environ), soit le non-respect des performances des composants si la température dépasse la valeur extrême de fonctionnement, soit la destruction de ces composants si cette température dépasse la valeur maximum admissible.

De tels incidents créent donc nécessairement des perturbations de fonctionnement du système électronique concerné. Or, ce type d'équipement nécessitant l'utilisation de connecteurs électriques et/ou thermiques est généralement très complexe et comporte une grande densité de cartes imprimées sous un faible volume, difficilement accessible. Il est donc aisé de comprendre qu'il est souhaitable d'éviter les perturbations de fonctionnement de ces circuits et donc d'assurer des connexions électriques et/ou thermiques présentant le moins de risques possibles.

Le système de connexion selon l'invention permet de résoudre aisément le problème posé et d'améliorer ainsi la fiabilité des équipements utilisant ce système. Dans ce but, un connecteur tel que celui décrit ci-dessus comportant au moins un contact électrique et/ou thermique qui vient s'appuyer contre les contacts électriques et/ou thermiques correspondants de la carte sous l'action d'une came, est caractérisé en ce que ladite came comporte au moins une partie plane dans sa position de verrouillage de la carte, de manière à créer une position d'équilibre stable de la came. Lorsqu'on provoque une légère rotation de la came autour de cette position stable, elle tend naturellement à revenir vers cette position. Pour déverrouiller la came, il faut franchir un «point dur» dont l'effet provoque une sensation tactile lors des opérations de déconnexion. De même, lors de l'opération de connexion, il est nécessaire de passer par ce «point dur» avant d'arriver à la position d'équilibre stable. Par ailleurs, le passage au-delà du «point dur» provoque généralement un «bruit» audible. La position de verrouillage de la carte correspond donc au passage d'un point dur ayant la double fonction de créer une sensation tactile et une sensation audible pour l'utilisateur. Les systèmes de connexion selon l'invention supportent très bien tous les essais en vibration et essais thermiques sans desserrage de ladite came.

De préférence, on munira la came de deux plats disposés symétriquement par rapport à la position d'équilibre stable de celle-ci correspondant à la position de déconnexion du système. L'avantage en est évidemment une possibilité de blocage par rotation dans l'un ou l'autre sens. Cela facilite également le montage des cames pour connecteurs situés à droite ou à gauche de la carte.

Selon un autre aspect, un système de connexion est caractérisé par une came comportant une première partie (DA) de rayon croissant jusqu'à une valeur $\rho 0$ correspondant à l'application d'une force progressive sur les contacts, une seconde partie (AC) de rayon décroissant jusqu'à une valeur minimale $\rho_{min}$ correspondant à un équilibre stable de la came en position de verrouillage et une troisième partie (CB) de rayon croissant jusqu'à une valeur maximum $R_{max}$ supérieure ou égale à $\rho 0$.

L'invention sera mieux comprise à l'aide des exemples de réalisation suivants donnés à titre non limitatif, conjointement avec les figures qui représentent:

— la fig. 1, un système d'interconnexion muni d'une came selon l'art antérieur,

— la fig. 2, un système d'interconnexion muni d'une came selon l'invention,

— la fig. 3, un mode préférentiel de réalisation de la came utilisée dans le système de la fig. 2,

— la fig. 4, une courbe montrant la variation du rayon de la came en fonction de l'angle de rotation de celle-ci,

— la fig. 5, une vue schématique du système selon l'invention dans le cas de vibrations.

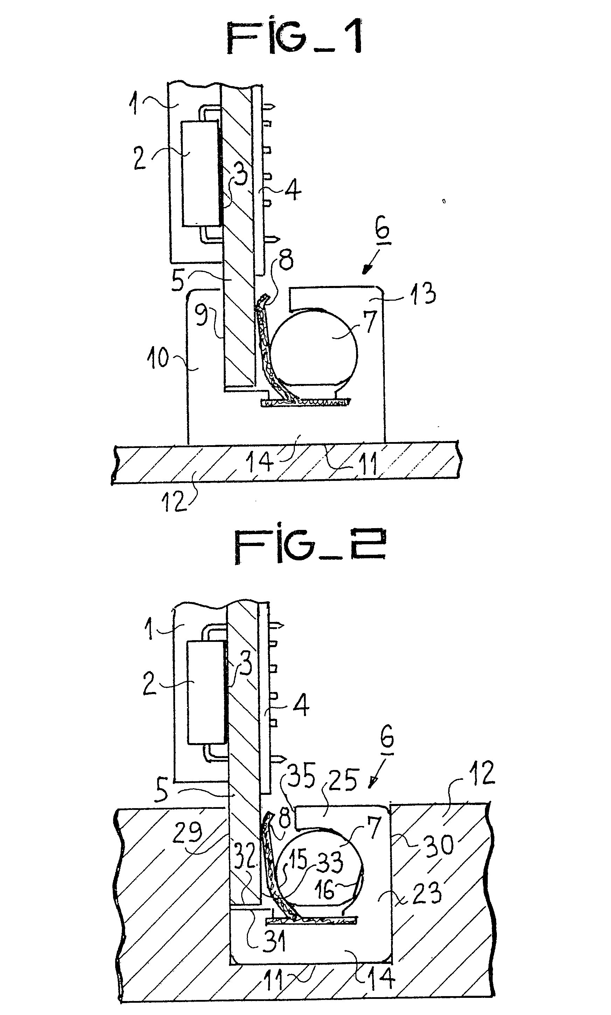

Sur la fig. 1 est représentée une carte constituée d'un circuit imprimé 4 revêtu d'un drain thermique 5 et sur laquelle est connecté un composant électronique 2 dissipant une grande quantité de chaleur. Entre le composant 2 et le drain thermique 5 est intercalé un joint thermique 3 qui est une pâte conductrice facilitant le transfert de calories entre les deux. Le drain thermique 5 est enfiché dans le connecteur 6 comportant deux parois sensiblement verticales 10 et 13 reliées par une paroi horizontale 14. La paroi verticale 10 est au contact du drain thermique 5 le long de sa face 9. Ce drain thermique 5 est placé contre la face 9 par l'intermédiaire d'un contact élastique 8 s'appuyant sur l'autre face du drain 5. Ce contact élastique 8 est maintenu en position par une came rotative 7 qui, suivant son orientation, permet l'introduction du drain thermique dans le connecteur ou son maintien dans celui-ci. Dans la position représentée sur la fig. 1, la came maintient le drain thermique au contact de la paroi 9. La paroi 14 du connecteur thermique 6 est au contact d'une paroi froide 12 elle-même reliée ou faisant partie du bâti extérieur de l'équipement électrique considéré. Il est à noter que selon une variante représentée sur cette figure, le contact élastique 8 peut être également un contact électrique dans la mesure où le circuit imprimé 4 se prolonge jusqu'à l'extrémité du drain thermique. Dans ce cas, le contact 8 comportera plusieurs contacts parallèles indépendants les uns des autres dans un axe perpendiculaire au plan de la figure. Bien entendu, dans ce cas, la base du contact 8 traverse la paroi 14 et la source froide 12 de manière à être relié électriquement à d'autres éléments extérieurs.

Sur la fig. 2 est représenté un système d'interconnexion thermique selon l'invention, système dans lequel les éléments ayant les mêmes fonctions portent les mêmes références. En premier lieu, il faut noter que le connecteur 6 est encastré dans la paroi froide 12 de manière à supprimer la paroi 10 du connecteur de la fig. 1. Comme dans le cas de la fig. 1, la came 7 plaque le contact 8 contre le drain thermique 5. Toutefois, selon l'invention, cette came 7 comporte deux parties planes 15 et 16 destinées à maintenir plus efficacement le drain thermique 5 et éviter la désolidarisation de celui-ci d'avec la paroi froide lors des vibrations ou chocs subis par l'équipement électrique incorporant ce système.

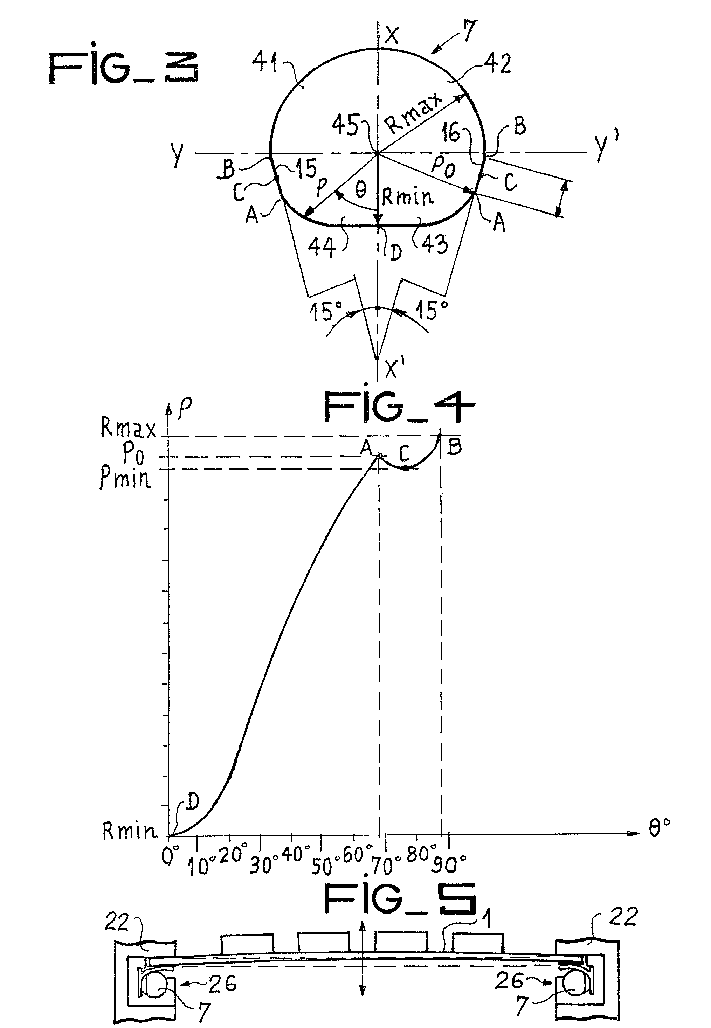

Cette came 7 munie de ses deux parties planes 15 et 16 va maintenant être décrite plus en détail à l'aide de la fig. 3, sur laquelle les mêmes éléments que ceux des figures précédentes portent les mêmes références. Sur cette figure, la came 7 a été divisée en quatre secteurs 41, 42, 43 et 44 délimités par les axes XX' et YY'. L'axe XX' est un axe de symétrie de la came passant par le point 45 qui est le centre des deux secteurs circulaires 41 et 42 de rayon identique $R_{max}$. Cette partie cylindrique de la came se termine sensiblement au niveau de l'axe YY' perpendiculaire à l'axe XX', l'intersection des deux axes étant le point 45. Les secteurs 43 et 44 comportent une partie de rayon minimum $R_{min}$ représentant la distance entre le point 45 et le point D. Ces secteurs 43 et 44 se terminent respectivement au point B par un rayon égal à $R_{max}$. Au point A de ces secteurs représentant un angle $\theta$ de l'ordre de 70° (voir fig. 4), la came comporte une partie plane AB faisant un angle avec l'axe XX' de l'ordre de 15°. Cet angle est inférieur à l'angle entre la tangente au point A à la partie arrondie AD et l'axe XX' de sorte que le rayon variable $\rho 0$ de la came passe par un minimum $\rho_{min}$ sensiblement au point C (voir fig. 4). La longueur AB et l'angle entre AB et l'axe XX' sont tels que la distance entre le point 45 et le point B ($R_{max}$) est supérieure à la distance $\rho 0$ entre le point 45 et le point A.

Il est aisé de comprendre à l'aide des fig. 3 et 4 le fonctionnement de la came dans le système de l'invention. La position de déconnexion ou d'ouverture du système selon l'invention correspond à la position du point D sensiblement le long de l'axe YY'. La connexion du système s'effectue par rotation de la came autour du point 45 dans un sens ou dans l'autre, ce qui par augmentationn du rayon $\rho 0$ provoque un plaquage progressif du contact 8 contre le drain 5 et un serrage de celui-ci contre la paroi 29 jusqu'au passage du «point dur» A. Au-delà de ce «point dur», la diminution du rayon $\rho 0$ jusqu'à une valeur $\rho_{min}$ correspondant au point C engendre une position d'équilibre stable dans laquelle une force sensiblement constante est appliquée par l'intermédiaire du contact 8 au drain thermique 5 sans possibilité de déconnexion de celui-ci sous l'action de vibrations. En effet, la déconnexion impose l'application d'une force suffisante pour passer au-delà du point A. Ainsi qu'on le constate sur la figure, la rotation de la came entre les points A et B (sensiblement entre 70° et 90° dans l'exemple représenté ici) correspond à une position d'équilibre stable, la position B n'étant en pratique jamais atteinte, car correspondant à une distance trop étroite entre la paroi 29 et le contact 8 pour l'épaisseur considérée du drain thermique 5.

La fig. 5 représente une vue schématique d'un système d'utilisation du connecteur selon l'invention. Ainsi qu'on peut le constater, le circuit imprimé 1 soumis à des vibrations (indiqué par des flèches sur la figure) ne peut se déconnecter des glissières thermiques grâce à la forme appropriée de la came malgré l'important mouvement d'oscillation de celui-ci qui provoquerait en l'absence des parties planes sur cette came une désolidarisation progressive du drain et du contact 8.

## Revendications

1. Connecteur pour carte imprimée (4, 5) portant des composants électriques (2) à relier à un circuit électrique et/ou une source froide, connecteur comportant au moins un contact électrique et/ou thermique (8) destiné à s'appuyer contre les contacts électriques et/ou thermiques correspondants de la carte sous l'action d'une came (7) pour rendre la carte solidaire du connecteur, caractérisé en ce que ladite came (7) comporte au moins une partie plane (15, 16) de manière à créer une position d'équilibre stable de celle-ci dans sa position de verrouillage de la carte.

2. Connecteur selon la revendication 1, dans lequel la came se déplace par rotation autour d'un axe, caractérisé en ce que la distance entre l'axe de rotation (45) de la came (7) et au moins un point (C) de la partie plane est inférieure à la plus petite

des distances ($\rho_{min}$) entre cet axe (45) et les extrémités (A, B) de la partie plane.

3. Connecteur selon l'une des revendications 1 ou 2, caractérisé en ce que la came (7) est symétrique par rapport à un plan passant par son centre de rotation et dans sa zone de plus faible rayon.

4. Connecteur selon l'une des revendications 1 à 3, caractérisé en ce que la partie plane (15, 16) de la came (7) est située entre son axe de rotation et le plan tangent à l'une des extrémités (A) de la partie plane (AB).

5. Connecteur de carte portant des composants électriques à relier à un circuit électrique et/ou une source froide, connecteur comportant au moins un contact électrique et/ou thermique (8) qui vient s'appuyer contre les contacts électriques et/ou thermiques correspondants de la carte sous l'action d'une came (7), caractérisé en ce que ladite came (7) comporte une première partie (DA) de rayon croissant jusqu'à une valeur $\rho 0$ correspondant à l'application d'une force progressive sur les contacts (8), une seconde partie (AC) de rayon décroissant jusqu'à une valeur minimale ($\rho_{min}$) correspondant à un équilibre stable de la came en position de verrouillage et une troisième partie (CB) de rayon croissant jusqu'à une valeur maximum ($R_{max}$) supérieure ou égale à $\rho 0$.

6. Système de connexion électrique et/ou thermique, caractérisé en ce qu'il comporte au moins deux connecteurs selon l'une des revendications 1 à 5, disposés en vis-à-vis entre lesquels est disposée une carte imprimée revêtue de composants électriques.


## Patentansprüche

1. Steckverbinder für eine Druckschaltungskarte (4, 5), die mit einem elektrischen Kreis und/oder einer kalten Quelle zu verbindende elektrische Bauteile (2) trägt, wobei der Steckverbinder mindestens einen elektrischen und/oder thermischen Kontakt (8) aufweist, der sich gegen die elektrischen und/oder thermischen entsprechenden Kontakte der Karte aufgrund der Wirkung einer Nocke (7) anlegt, um die Karte und den Steckverbinder aneinander zu befestigen, dadurch gekennzeichnet, dass die Nocke (7) mindestens einen ebenen Bereich (15, 16) enthält, so dass sich eine stabile Gleichgewichtslage der Nocke in der verriegelten Stellung der Karte ergibt.

2. Steckverbinder nach Anspruch 1, bei dem die Nocke um eine Achse drehbar ist, dadurch gekennzeichnet, dass der Abstand zwischen der Drehachse (45) der Nocke (7) und mindestens einem Punkt (C) des ebenen Bereichs geringer als der kleinste der Abstände ($\rho_{min}$) zwischen dieser Achse (45) und den Enden (A, B) des ebenen Bereichs ist.

3. Steckverbinder nach einem der Ansprüche 1 oder 2, dadurch gekennzeichnet, dass die Nocke (7) symmetrisch bezüglich einer Ebene ist, die durch ihr Drehzentrum und in der Zone kleinsten Radius verläuft.

4. Steckverbinder nach einem der Ansprüche 1 bis 3, dadurch gekennzeichnet, dass der ebene Bereich (15, 16) der Nocke (7) zwischen der Drehachse und der Ebene liegt, die eines der Enden (A) des ebenen Bereichs (AB) tangiert.

5. Steckverbinder für eine karte, die elektrische, an einen elektrischen kreis und/oder eine kalte Quelle anzuschliessende Bauteile trägt, wobei der Steckverbinder mindestens einen elektrischen und/oder thermischen Kontakt (8) aufweist, der sich gegen die elektrischen und/oder thermischen entsprechenden Kontakte der Karte aufgrund der Wirkung einer Nocke (7) anlegt, dadurch gekennzeichnet, dass die Nocke (7) einen ersten Bereich (DA) zunehmenden Radius bis zu einem Wert $\rho 0$ entsprechend der Anwendung einer progressiven Kraft, die auf die Kontakte (8) wirkt, und einen zweiten Bereich (AC) abnehmenden Radius bis zu einem Minimalwert ($\rho_{min}$) entsprechend einem Gleichgewicht der Nocke in der verriegelten Stellung und einen dritten Bereich (CB) zunehmenden Radius bis zu einem Maximalwert ($R_{max}$) grösser oder gleich $\rho 0$ aufweist.

6. Elektrisches und/oder thermisches Verbindungssystem, dadurch gekennzeichnet, dass es mindestens zwei Steckverbinder nach einem der Ansprüche 1 bis 5 enthält, die einander gegenüberliegend angeordnet sind, wobei eine mit elektrischen Bauteilen bestückte Druckschaltungskarte zwischen ihnen liegt.


## Claims

1. A connector for a printed board (4, 5) bearing electrical components (2) which are to be connected to an electrical circuit and/or a cold source, the connector comprising at least one electrical and/or thermal contact (8) conceived to be applied against the corresponding electrical and/or thermal contacts of the board under the action of a cam (7) for rendering said board integral with the connector, characterized in that said cam (7) comprises at least one plane area (15, 16) such that a stable equilibrium position of said cam is created in the blocking position of the board.

2. A connector according to claim 1, in which the cam can be displaced by rotation about an axis, characterized in that the distance between the rotation axis (45) of the cam (7) and at least one point (D) of the plane area is smaller than the smallest of the distances ($\rho_{min}$) between said axis (45) and the ends (A, B) of the plane area.

3. A connector according to one of claims 1 or 2, characterized in that the cam (7) is a symmetrical cam with respect to a plane passing through the center of rotation and in its zone of smallest radius.

4. A connector according to one of claims 1 to 3, characterized in that the plane area (15, 16) of the cam (7) is situated between its rotation axis and the tangential plane at one of the ends (A) of the plane area (AB).

5. A connector for a board bearing electrical components which are to be connected to an electrical circuit and/or a cold source, the connector comprising at least one electrical and/or thermal contact (8) which is applied against the corresponding electrical and/or thermal contacts of the board under the action of a cam (7), characterized in that said cam (7) comprises a first part (DA) having an increasing radius up to a value $\rho 0$ corresponding to the application of a progressive force to the contacts (8), a second part (AC) of decreasing radius down to a minimum value ($\rho_{min}$) corresponding to a stable equilibrium of the cam in the blocking position, and a third part (CB) having an increasing radius up to a maximum value ($R_{max}$) at least equal to $\rho 0$.

6. An electrical and/or thermal connection system, characterized in that it comprises at least two connectors according to one of the claims 1 to 5, in face-to-face relationship, a printed board bearing electrical components being disposed between these connectors.

# FIG_1

# FIG_2

FIG_3

FIG_4

FIG_5